# EUROPÄISCHE PATENTANMELDUNG

(11) **EP 2 341 533 A2**
(43) Veröffentlichungstag der Anmeldung: **06.07.2011**
(21) Anmeldenummer: 11002935.2
(22) Anmeldetag: 28.07.2008
(51) Int. Cl.: H01L 23/495

(54) **Aufbau- und Verbindungstechnik von Modulen mittels aus einer Ebene heraus gebogenen metallischen Stanzgitter oder Stanzbiegeteilen**

(30) Priorität: 23.08.2007 DE 102007039916
(62) Teilanmeldung aus: 08786502.8
(71) Anmelder: Siemens Aktiengesellschaft, 80333 Munich (DE)
(72) Erfinder: Kaspar, Michael, Dr., 85640 Putzbrunn (DE); Schimetta, Gernot, Dr., 81541 München (DE); Weidner, Karl, 81245 München (DE); Zapf, Jörg, 81927 München (DE)

(57) **Zusammenfassung**

Die vorliegende Erfindung betrifft Module (1) mit mindestens einem ungehäusten elektronischen Bauelement (2), insbesondere ungehäusten Halbleiterbauelement oder ungehäusten Halbleiterleistungsbauelement, mit jeweils mindestens einer auf einer Oberseite und/oder Unterseite angeordneten Anschlussfläche (3) zur elektrischen Kontaktierung und/oder zur Befestigung, wobei das mindestens eine Bauelement (2) jeweils zwischen Substraten (5), derart positioniert ist, dass die Anschlussflächen (3) jeweils mit, den Anschlussflächen (3) gegenüberliegenden, elektrischen Leitern (7) und/oder Befestigungsflächen auf den Substraten (5) elektrisch kontaktiert und/oder befestigt sind. Es ist Aufgabe eine kostengünstige elektrische Kontaktierung insbesondere mit einer hohen Integrationsdichte, niederinduktivem Verhalten, hoher Stromtragfähigkeit, guter Kühlung und hoher Zuverlässigkeit bei elektrischer und thermischer Zykelbeanspruchung bereit zu stellen. Die Erfindung zeichnet sich dadurch aus, dass von den Substraten (5) mindestens eines ein aus einer Ebene heraus gebogenes metallisches Stanzgitter oder Stanzbiegeteil (9) ist, das mit sich in einer Ebene erstreckenden metallischen Stanzgittern oder Stanzbiegeteilen (11) kombiniert werden kann. Das Modul (1) eignet sich insbesondere für den Hochspannungsbereich größer 1000V und entsprechende elektronische Bauelemente (2).

## Beschreibung

Die vorliegende Erfindung betrifft ein Modul gemäß dem Oberbegriff des Hauptanspruchs sowie ein Verfahren gemäß dem Oberbegriff des Nebenanspruchs.

Herkömmlicherweise werden zur kostengünstigen elektrischen Kontaktierung von einem oder mehreren ungehäusten elektronischen Bauelementen und/oder passiven Bauelementen, insbesondere in der Leistungselektronik Direct Copper Bonding-(DCB-) Keramiken als Substrat verwendet, wobei die elektronischen Bauelemente auf der Rückseite flächig aufgelötet sind und eine Kontaktierung der Bauelementeoberseite mittels Dickdrahtbonden oder alternativ mittels planaren Kontaktierens gemäß der WO 03030247 ausgeführt wird. Gemäß dem planaren Kontaktieren wird das Dickdrahtbonden durch Laminieren einer Isolationsfolie, Öffnen von Kontaktfenstern, anschließender Laserablation sowie durch die Erzeugung einer planaren Verbindung mittels galvanisch abgeschiedener Metallisierung ersetzt. Der Inhalt der WO 03030247 gehört hiermit vollständig zur Offenbarung dieser Anmeldung. Bei der Erzeugung einer DCB-Keramik werden auf Ober- und Unterseite einer Keramik Kupferplatten aufgewalzt und bei ca. 1080°C mit dieser formschlüssig verbunden. Anschließend wird zumindest eine der beiden Kupferseiten nasschemisch strukturiert.

Herkömmliche Kontaktierungen weisen die Nachteile einer niedrigen Integrationsdichte, sowie Nachteile hoher Streuinduktivitäten im Bereich der Drahtbondverbindungen, wie auch einer geringen Stromtragfähigkeit, einer schlechten Kühlung und eine niedrige Zuverlässigkeit bei elektrischer und thermischer Zykelbeanspruchung auf.

Es ist Aufgabe der vorliegenden Erfindung bei ungehäusten elektronischen Bauelementen, insbesondere der Leistungselektronik, insbesondere für den Hochspannungsbereich größer 1000V, eine kostengünstige elektrische Kontaktierung insbesondere mit einer hohen Integrationsdichte, niederinduktivem Verhalten, hoher Stromtragfähigkeit, guter Kühlung und hoher Zuverlässigkeit bei elektrischer und thermischer Zykelbeanspruchung bereit zu stellen.

Die Aufgabe wird durch ein Modul gemäß dem Hauptanspruch sowie ein Verfahren gemäß dem Nebenanspruch zur Herstellung eines derartigen Moduls gelöst.

Ein dreidimensional geformter Leadframe ist eine elektrisch leitende, insbesondere metallische, dreidimensional geformte Struktur, beispielsweise in Form eines Gitters, das beispielsweise durch kostengünstiges Stanzen, Ätzen und/oder Biegen, beispielsweise auf einer Rolle oder in Streifen, hergestellt wird. Dreidimensional geformt bedeutet aus einer Ebene herausgebogen. Als Materialien eignen sich vorzugsweise Cu-Legierungen, beispielsweise Zinnbronze CuSn6 oder SB02, das heißt, Cu98Fe2. Typische Dicken liegen im Bereich von 0,2 bis 0,5 mm. Im Unterschied zu den hier definierten dreidimensional geformten Leadframes werden ebenso ebene Leadframes verwendet. Der Sammelbegriff für dreidimensional geformte Leadframes und ebene Leadframes ist Leadframe. In den Ausführungsbeispielen ist ein dreidimensional geformter Leadframe als Stanzbiegeteil oder Stanzgitter verwendet.

Die Kombination einer dreidimensionalen Formung von Leadframes, die Anordnung von elektronischen Bauelementen zwischen zwei Leadframes, sowie die Verwendung eines spritzgegossenen Kunststoffs als Isolationsmaterial bewirkt zahlreiche Vorteile. Besonders vorteilhaft können kostengünstige Materialien verwendet, eine hohe Stromtragfähigkeit durch dicke Leadframes aus elektrisch hochleitfähigem Material und eine niederinduktive Kontaktierung der Chips bereitgestellt werden. Weitere vorteilhafte Ausgestaltungen finden sich in den Unteransprüchen.

Gemäß einer weiteren vorteilhaften Ausgestaltung können zusätzlich zu den dreidimensional geformten Leadframes ebene Leadframes verwendet werden. Auf diese Weise können elektronische Bauelemente einfach kontaktiert und/oder befestigt werden.

Gemäß einer weiteren vorteilhaften Ausgestaltung ist bei Verwendung von zwei Bauelementen ein dreidimensional geformter Leadframe mit Anschlussflächen auf der Oberseite des ersten Bauelements und auf der Unterseite des zweiten Bauelements elektrisch kontaktiert und/oder befestigt.

Gemäß einer weiteren vorteilhaften Ausgestaltung ist jeweils ein ebener Leadframe mit Anschlussflächen der anderen Seiten des jeweiligen Bauelements, das heißt, des ersten und des zweiten Bauelements, elektrisch kontaktiert und/oder befestigt.

Gemäß einer weiteren vorteilhaften Ausgestaltung ist mindestens ein weiterer dreidimensional geformter Leadframe optional mit weiteren elektrisch kontaktierten und/oder befestigten Bauelementen derart elektrisch kontaktiert und/oder befestigt, dass die Bauelemente in der Regel auf Ober- und Unterseite auf dreidimensional geformten Leadframes umgeben sind. Auf diese Weise ist besonders einfach eine dreidimensionale Stapelung ausführbar.

Gemäß einer weiteren vorteilhaften Ausgestaltung ist jeweils ein ebener Leadframe mit, von dreidimensional geformten Leadframes freien Anschlussflächen der Bauelemente elektrisch kontaktiert und/oder befestigt. Auf diese Weise können besonders einfach Außenkontakte erzeugt werden.

Gemäß einer weiteren vorteilhaften Ausgestaltung ist ein Metallkörper für eine elektrische Funktion und/oder zur Kühlung und/oder zur Vergrößerung der Dicke eines dreidimensional geformten Leadframes, an diesem und/oder an einem Bauelement befestigt und/oder elektrisch kontaktiert.

Gemäß einer weiteren vorteilhaften Ausgestaltung weisen die verwendeten Leadframes verschiedene Dicken und/oder Materialien auf.

Gemäß einer weiteren vorteilhaften Ausgestaltung beabstanden ein auf dem dreidimensional geformten Leadframe geformter Distanzhalter und/oder ein entsprechend geformter dreidimensional geformter Leadframe, zur Erzeugung hoher Isolationsfestigkeit, den dreidimensional geformten Leadframe von Kanten des Bauelements.

Gemäß einer weiteren vorteilhaften Ausgestaltung sind zur Vermeidung von Kurzschlüssen durch dreidimensional geformte Leadframes erzeugte Brücken unterbrochen. Derartige Brücken waren vor der Kontaktierung zur mechanischen Stabilisierung des dreidimensional geformten Leadframes erforderlich.

Gemäß einer weiteren vorteilhaften Ausgestaltung ist mindestens ein dreidimensional geformter Leadframe als Kühlkörper ausgebildet und/oder über eine Kontaktfläche mit mindestens einer Wärmesenke formschlüssig verbunden. Auf diese Weise ergeben sich wirksame Kühlungsmöglichkeiten durch Wärmesenken, die beidseitig am Modul erzeugt werden können.

Gemäß einer weiteren vorteilhaften Ausgestaltung sind freie Bereiche zwischen den dreidimensional geformten Leadframes, den falls vorhanden ebenen Leadframes und den Bauelementen mit elektrisch isolierendem Material gefüllt. In diesem Material können Kühlkanäle oder Heatpipes erzeugt sein. Ebenso auf diese Weise ergeben sich wirksame Kühlungsmöglichkeiten, wenn das elektrisch isolierende Material thermisch leitend ausgeführt ist, z.B. durch Füllung mit Aluminiumoxid-Partikel. Gemäß einer weiteren vorteilhaften Ausgestaltung sind elektrische Anschlüsse des Moduls nach außen durch von isolierendem Material freien Leadframes bereitgestellt.

Gemäß einer weiteren vorteilhaften Ausgestaltung ist der Ausdehnungskoeffizient des elektrisch isolierenden Materials an das Material der Leadframes angepasst.

Gemäß einer weiteren vorteilhaften Ausgestaltung wird zur Erzeugung einer hohen Zykelfestigkeit der Ausdehnungskoeffizient des elektrisch isolierenden Materials derart ausgewählt, dass eine Verspannung aufgebaut wird, die eine Verbindungsschicht - insbesondere eine Lotschicht - zwischen Bauelement und dem Leadframe mechanisch entlastet. Auf diese Weise ergibt sich eine besonders hohe thermomechanische und elektrische Zykelfestigkeit.

Gemäß dem erfindungsgemäßen Verfahren erfolgt ein elektrisches Kontaktieren und/oder Befestigen, insbesondere mittels Löten, Reaktionslöten zu intermetallischen Phasen, Schweißen, insbesondere Laserschweißen, leitendes und/oder nichtleitendes Kleben.

Gemäß einer weiteren vorteilhaften Ausgestaltung wird vor dem elektrischen Kontaktieren von kleinen Anschlussflächen, beispielsweise Gatekontakten und/oder Steuerkontakten ein Erzeugen von Bumps auf der Seite des Bauelements und/oder auf der Seite des Leadframes. Derartige Bumps sind beispielsweise Lotbumps, Studbumps oder Leiterkleberdepots. Im Falle von Lotbumps können diese entweder durch den Lötvorgang selbst erzeugt werden, oder bereits davor, beispielsweise am Wafer, d.h. es kann ein sog. Wafer Level Processing ausgeführt werden. In diesem Fall ist es ausreichend, vor dem eigentlichen Lötprozess Flussmittel an die Kontaktstelle zu bringen.

Gemäß einer weiteren vorteilhaften Ausgestaltung werden vor dem elektrischen Kontaktieren von kleinen Anschlussflächen Nasen oder Kontaktzungen in dem Leadframe, insbesondere mittels Stanzen und/oder Prägen erzeugt. Auf diese Weise wird die Kontaktierung von kleinen Anschlussflächen vereinfacht.

Gemäß einer weiteren vorteilhaften Ausgestaltung wird der dreidimensional geformte Leadframe erst nach dem elektrischen Kontaktieren und/oder Befestigen des Bauelements und/oder des Metallkörpers und/oder des Distanzhalters in seine dreidimensionale Form gebracht.

Gemäß einer weiteren vorteilhaften Ausgestaltung werden vor der Kontaktierung zur mechanischen Stabilisierung des dreidimensionalen Leadframes erzeugte Brücken beispielsweise mittels Stanzen, Bohren oder Laserschneiden getrennt. Die Trennung ist dabei auf einfache Weise ausführbar.

Gemäß einer weiteren vorteilhaften Ausgestaltung ist das elektrisch isolierende Material beispielsweise ein Epoxid. Das Einbringen des Epoxy bzw. des isolierenden Materials in die freien Bereiche erfolgt besonders vorteilhaft mittels Spritzguss und insbesondere mittels eines Transfermoldprozesses. Auf diese Weise wird ein kostengünstiges Package, beruhend auf etablierten Einzelprozessen mit besonderer Eignung für die Leistungselektronik, erzeugt. Lediglich wenige kostengünstige Prozess-Schritte, beispielsweise Roll-to-Roll-Prozesse sind notwendig.

Gemäß einer weiteren vorteilhaften Ausgestaltung kann ein mehrstufiges Spritzgießen ausgeführt werden, wobei nach ersten Teilvergüssen Leadframes beispielsweise frei geschnitten und/oder gebohrt werden. Es kann ein Spritzgießen zum Auffüllen der entstandenen Trennstellen und/oder Bohrungen nachfolgen. Auf diese Weise wird eine hohe Isolationsfestigkeit ebenso für feuchte oder korrosive Umgebungen, beispielsweise bei Salznebel, bereitgestellt.

Die vorliegende Erfindung wird anhand von Ausführungsbeispielen in Verbindung mit den Figuren näher beschrieben. Es zeigen
- Figur 1: ein erstes Ausführungsbeispiel eines erfindungsgemäßen Moduls;
- Figur 2: ein zweites Ausführungsbeispiel eines erfindungsgemäßen Moduls;
- Figur 3: ein erstes Ausführungsbeispiel eines erfindungsgemäßen Verfahrens zur Herstellung eines Moduls.

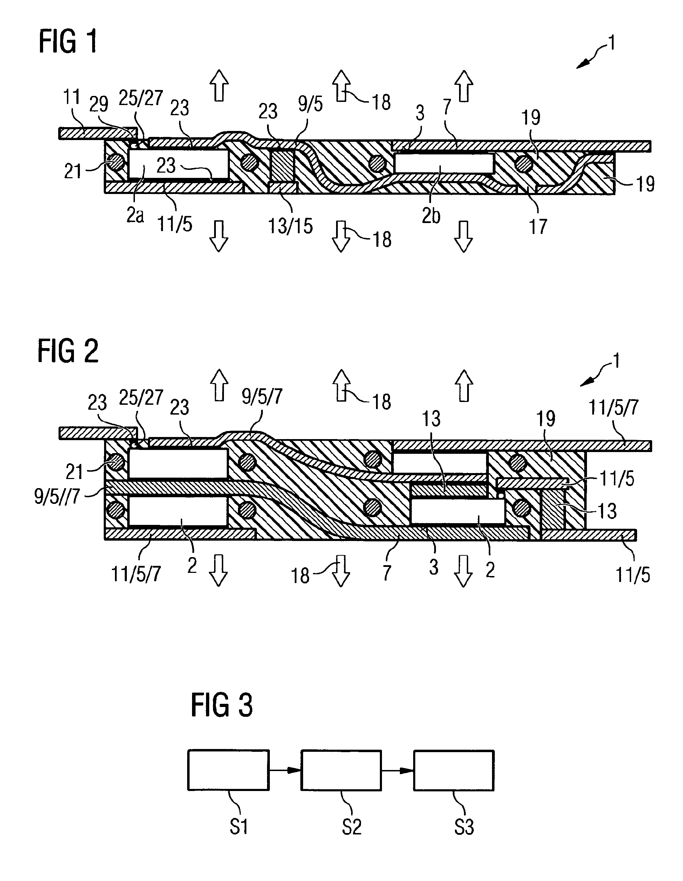

Figur 1 zeigt ein erstes Ausführungsbeispiel eines erfindungsgemäßen Moduls 1. Ein dreidimensional geformter Leadframe 9 ist hier beispielsweise mit dem Material CuSn6 erzeugt, wobei dieser durch Stanzen und Formen ausgebildet wurde. Auf diesen dreidimensional geformten Leadframe 9 wurden ein erstes elektronisches Bauelement 2a, und zwar ein IGBT (Insolated Gate Bipolar Transistor), und eine Diode aufgesetzt und mittels Löten elektrisch kontaktiert und befestigt bzw. fixiert. Des Weiteren wird ein zweiter ebener Leadframe 11 justiert aufgesetzt und mit den Kontakten des IGBTs und der Diode durch den gleichen oder einen weiteren Lötprozess verbunden. Die Kontaktierung des kleinen Gatepads 25 wird durch eine geprägte Kontaktzunge 29 eines weiteren ebenen Leadframes 11 und einem vorab auf dem IGBT erzeugten Lotband 27 erleichtert. An einer Stelle des dreidimensional geformten Leadframes 9 ist eine Brücke 17 mittels Laser getrennt worden. Durch Transfermolden wurden die Freiräume mit Epoxy als ein elektrisch isolierendes und/oder thermisch leitendes Material 19 gefüllt, wobei für eine spätere Kühlung Kühlkanäle 21 freigehalten wurden.

Das heißt das Modul 1 weist zwei elektronische Bauelemente 2, und zwar ein erstes Bauelement 2a und ein zweites Bauelement 2b auf. Beide Bauelemente 2 weisen jeweils mindestens eine auf einer Oberseite und/oder Unterseite angeordnete Anschlussfläche 3 zur elektrischen Kontaktierung und zur Befestigung auf, wobei die beiden Bauelemente 2, 2a, 2b jeweils zwischen Substraten 5 derart positioniert sind, dass die Anschlussflächen 3 jeweils mit, den Anschlussflächen 3 gegenüber liegenden, elektrischen Leitern 7 und Befestigungsflächen auf den Substraten 5 elektrisch kontaktiert und befestigt sind. Figur 1 zeigt insbesondere drei Substrate 5, und zwar einen dreidimensional geformten Leadframe 9 mit Anschlussflächen 3 auf der Oberseite des ersten Bauelements 2a und auf der Unterseite des zweiten Bauelements 2b. Des Weiteren sind jeweils zwei ebene Leadframes 11 an der Unterseite des IGBTs 2a und auf der Oberseite der Diode 2b erzeugt. Die Leadframes 9, 11 dienen als elektrische Leiter 7. Figur 1 zeigt zudem einen Metallkörper 13 für eine elektrische Funktion und/oder zur Kühlung an dem dreidimensional geformten Leadframe 9 wärmeleitend befestigt und elektrisch kontaktiert. Ein derartiger Metallkörper 13 kann ebenso an einem Bauelement 2 wärmeleitend befestigt und/oder elektrisch kontaktiert sein. Ein derartiger Metallkörper 13 kann beispielsweise als Kupferblock ausgebildet sein. Zudem dient der Metallkörper 13 in Figur 1 ebenso als Distanzhalter 15, der zur Erzeugung einer hohen Isolationsfestigkeit den dreidimensional geformten Leadframe 9 von Kanten des Bauelements 2a beabstandet. Des Weiteren ist der dreidimensional geformte Leadframe 9 entsprechend zur Erzeugung einer hohen Isolationsfestigkeit geformt. Zur Vermeidung von Kurzschlüssen ist die durch den dreidimensional geformten Leadframe 9 erzeugte Brücke unterbrochen. Bezugszeichen 18 bezeichnet Wärmesenken. Der dreidimensional geformte Leadframe 9 ist über seine Kontaktflächen mit beidseitigen Wärmesenken 18 formschlüssig verbunden. Das elektrisch isolierende und thermisch leitende Material 19 ist in freie Bereichen zwischen den dreidimensional geformten Leadframe 9, den ebenen Leadframes 11 und den Bauelementen 2 gefüllt, wobei Raum für Kühlkanäle 21 geschaffen ist. Bezugszeichen 23 bezeichnet Lotschichten, die die elektrische Kontaktierung und Befestigung erzeugen. Die kleine Gateanschlussfläche 25 des Bauelements 2a, und zwar des IGBTs, ist zur elektrischen Kontaktierung mittels auf der Bauelementeseite oder Leadframeseite erzeugten Lotbump 27 elektrisch kontaktiert worden. Zudem weist der ebene Leadframe 11 eine Kontaktzunge 29 zur Vereinfachung der elektrischen Kontaktierung auf.

Figur 2 zeigt ein zweites Ausführungsbeispiel eines erfindungsgemäßen Moduls 1. Dabei gleicht der Aufbau dem der Figur 1, wobei anstelle von einem dreidimensional geformten Leadframe 9 zwei dreidimensional geformte Leadframes 9 verwendet werden. Die verbleibenden Leadframes sind ebene Leadframes 11. Es werden gleiche Bezugszeichen entsprechend Figur 1 verwendet. Gemäß Figur 2 werden vier elektronische Bauelemente 2 verwendet. Auf der linken Seite der Figur 2 ist ebenso die elektrische Kontaktierung einer kleinen Anschlussfläche 25 mittels eines Lotbump 27 und einer Kontaktzunge 29 dargestellt. Gemäß Figur 2 ist im Unterschied zur Figur 1 ein zweiter dreidimensional geformter Leadframe 9 derart elektrisch kontaktiert und befestigt, dass die vier Bauelemente 2 bis auf zwei Seiten auf deren Ober- und Unterseite von dreidimensional geformten Leadframes 9 umgeben sind. Es ist jeweils ein ebener Leadframe 11 mit, von den dreidimensional geformten Leadframes freien Anschlussflächen 3 der Bauelemente 2 elektrisch kontaktiert und befestigt. Der zweite dreidimensional geformte Leadframe 9 ist mit weiteren elektronischen Bauelementen 2 elektrisch kontaktiert und befestigt. Alle Leadframes 9, 11 dienen als Substrate 5 und stellen elektrische Leiter 7 bereit. Figur 2 zeigt einen Metallkörper 13 für eine elektrische Funktion, und zwar für die elektrische Kontaktierung eines ebenen Leadframes 11 mit einem weiteren ebenen Leadframe 11 zur elektrischen Kontaktierung einer kleinen Gateanschlussfläche 25 eines IGBTs rechts unten in Figur 2. Des Weiteren zeigt Figur 2 einen weiteren Metallkörper 13, und zwar einen Kupferblock, zur Vergrößerung der Dicke des oberen dreidimensional geformten Leadframes 9, so dass eine elektrische Kontaktierung und Befestigung hinsichtlich der Gesamtdicke des Moduls 1 erzeugt werden kann. Das elektrisch isolierende Material 19, ist beispielsweise ein mit wärmeleitenden anorganischen Partikeln gefülltes, spritzguss- oder transfermold-fähiges Polymer. Bezugszeichen 21 bezeichnet den Raum für Kühlkanäle. Auf der Oberseite und der Unterseite des Moduls 1 sind Wärmesenken 18 erzeugbar.

Figur 3 zeigt ein Ausführungsbeispiel eines Verfahrens zur Herstellung eines erfindungsgemäßen Moduls 1.

Ein wesentlicher Schritt S1 ist das elektrische Kontaktieren und/oder Befestigen des Bauelements 2 und/oder des Metallkörpers 13 und/oder des Distanzhalters 15, insbesondere mit dem mindestens einen dreidimensional geformten Leadframe 9 oder mit dem mindestens einen ebenen Leadframe 11, insbesondere mittels Löten, Reaktionslöten zu intermetallischen Phasen, Laserschweißen, leitendes und/oder nicht leitendes Kleben. Metallkörper 13 können ebenso auf elektronische Bauelemente 2 befestigt sein. Ein Metallkörper 13 wird für eine elektrische Funktion und/oder zur Kühlung und/oder zur Vergrößerung der Dicke eines dreidimensional geformten Leadframes 9, an diesem und/oder an einem Bauelement 2 Wärme leitend befestigt und/oder elektrisch kontaktiert. Eine elektrische Funktion sind beispielsweise die eines elektrischen Widerstands oder einer Spule. Ein weiterer Schritt S3 ist ein mittels beispielsweise mittels Stanzen, Bohren oder Laserschneiden erfolgendes Trennen von Brücken 17 des dreidimensional geformten Leadframes 9, die vor der Kontaktierung zur mechanischen Stabilität des dreidimensional geformten Leadframes 9 notwendig waren. Ein weiterer wesentlicher Schritt S3 ist, dass das elektrisch isolierende Material 19 beispielsweise ein Epoxy ist und/oder mittels Spritzguss insbesondere mittels eines Transfermoldprozesses eingespritzt wird, und zwar in freie Bereiche, zwischen den dreidimensional geformten Leadframes 9, den ebenen Leadframes 11 und den Bauelementen 2. Es kann ein Raum für Kühlkanäle 21 geschaffen sein.

Grundlage der vorliegenden Erfindung ist also die Verwendung von dreidimensional geformten Leadframes 9. Diese können ebenso als metallische Stanzgitter oder Stanzbiegeteile bezeichnet werden. Auf diese Stanzgitter werden nun die Bauelemente 2 positioniert aufgesetzt und fixiert. Die Kontaktierung kann beispielsweise durch Löten, ebenso Reaktionslöten zu intermetallischen Phasen, Laserschweißen und/oder Kleben, und zwar leitfähig und nicht leitend, erfolgen. Auf die gleiche Weise können auch Kupferblöcke 13 kontaktiert werden, die zur elektrischen Funktion und/oder Kühlung notwendig sind. Die Formung des Stanzgitters kann ebenso nach dem Aufsetzen der Bauelemente 2 erfolgen. Nun wird ein möglicherweise ebenfalls bestücktes zweites Stanzgitter so positioniert aufgesetzt, dass elektronische Bauelemente beziehungsweise Chips in der Regel auf deren Vorder- und Rückseite von Stanzgittern umgeben sind. Das zweite Stanzgitter kann in Dicke und Material von dem ersten Stanzgitter abweichen. Die Kontaktierung erfolgt durch die vorstehend genannten Verfahren. Zur Kontaktierung von kleineren Anschlusspads 25, beispielsweise Gatekontakten und Steuerkontakten kann es notwendig sein, vor der Kontaktierung Bumps auf der Chipseite oder Leadframeseite zu erzeugen. Dies können beispielsweise Lotbumps 27, Studbumps oder Leitkleberdepots sein. Im Falle von Lotbumps 27 können diese entweder durch den Lötvorgang selbst erzeugt werden oder bereits davor, beispielsweise am Wafer der verwendeten Leistungshalbleiter. Dies wird Wafer Level Processing genannt. In diesem Fall ist es ausreichend, vor dem eigentlichen Lötprozess Flussmittel an die Kontaktstelle zu bringen. Zur leichteren Kontaktierung derartiger kleinerer Pads 25 können auch Nasen oder Kontaktzungen 29 in das Leadframe 9 oder 11 gestanzt oder geprägt werden. Durch aufgelötete Distanzhalter 15, die beispielsweise aus Kupfer bestehen, oder entsprechend geformten Leadframes 9 kann erreicht werden, dass Leadframe 9 und Kanten der Bauelemente 2 ausreichend weit voneinander entfernt sind, so dass eine hohe Isolationsfestigkeit erreichbar ist. Zur Vermeidung von Kurzschlüssen und Herstellung der letztendlichen Verdrahtung kann es nun notwendig sein, bestimmte Leadframebrücken 17 zu trennen, die vor der Kontaktierung zur mechanischen Stabilisierung des Stanzgitters notwendig waren. Eine derartige Trennung kann beispielsweise mittels Stanzen, Bohren oder Laserschneiden erfolgen. Zur besseren Wärmeabfuhr und Wärmespreizung können Kühlkörper auf die Leadframes 9, 11 oder auf die Bauelemente 2 gesetzt werden und wärmeleitend durch Löten oder Kleben fixiert werden. Auch der Leadframe 9, 11 kann zu einem Kühlkörper ausgestaltet werden und über eine Kontaktfläche mit mindestens einer Wärmesenke 18 formschlüssig verbunden werden. Abschließend werden die freien Bereiche zwischen den beiden Leadframes 9 und Bauelementen 2 durch einen Spritzgussprozess durch isolierendes Material 19 gefüllt. Dabei können auch Kanäle 21 freigehalten werden, durch die ein Kühlmedium Wärme abführen kann. Der elektrische Anschluss des Moduls 1 nach außen erfolgt durch nicht umspritzte Kontakte der Leadframes 9, 11. Der Spritzgussprozess ist vorzugsweise ein Transfermoldprozess. Die isolierende Masse 19 ist beispielsweise ein hochgefülltes Epoxy. Die elektrisch isolierende Masse 19 kann beispielsweise einen an das Leadframematerial angepassten Ausdehnungskoeffizienten aufweisen. Alternativ kann der Ausdehnungskoeffizient des Vergussmaterials 19 derartig gewählt werden, dass eine Verspannung aufgebaut wird, die die Verbindungsschicht - insbesondere Lotschicht - zwischen elektronischem Bauelement 2 und Leadframe 9, 11 mechanisch derart entlastet, dass eine hohe Zykelfestigkeit bereitgestellt wird. Des Weiteren können ebenso drei oder mehr Leadframes 9 mit Bauelementen 2 aufeinander gesetzt und partiell wie vorstehend beschrieben kontaktiert werden. Der abschließende Spritzgussprozess schließt auch hier bis auf mögliche Kühlkanäle 21 alle Freiräume zwischen Leadframes 9, 11 und Bauelementen 2. Der Spritzgussprozess kann auch mehrstufig erfolgen, wobei beispielsweise nach den ersten Teilvergüssen Leadframes 9, 11 frei geschnitten beziehungsweise gebohrt werden können. Der darauf folgende Spritzgussprozess füllt dann die entstandenen Trennstellen beziehungsweise Bohrungen auf. Das elektrisch isolierende und thermisch leitfähige Material 19 stellt eine Isolationsfestigkeit ebenso bei feuchter und/oder korrosiver Umgebung, beispielsweise bei Salznebel, sicher.

## Patentansprüche

1. Modul (1) mit mindestens einem ungehäusten elektronischen Bauelement (2), mit jeweils mindestens einer auf einer Oberseite und/oder Unterseite angeordneten Anschlussfläche (3) zur elektrischen Kontaktierung, wobei das mindestens eine Bauelement (2) jeweils zwischen Substraten (5), derart positioniert ist, dass die Anschlussflächen (3) jeweils mit, den Anschlussflächen (3) gegenüberliegenden, elektrischen Leitern (7) auf den Substraten (5) elektrisch kontaktiert sind, wobei von den Substraten (5) mindestens eines ein aus einer Ebene heraus gebogenes metallisches Stanzgitter oder Stanzbiegeteil (9) ist, **dadurch gekennzeichnet, dass** freie Bereiche, zwischen den aus einer Ebene heraus gebogenen metallischen Stanzgittern oder Stanzbiegeteilen (9), sich in einer Ebene erstreckenden metallischen Stanzgittern oder Stanzbiegeteilen (11) und den Bauelementen (2), mit elektrisch isolierendem und thermisch leitfähigem Material (19) gefüllt sind. wobei darin Kühlkanäle (21) und/oder Heatpipes erzeugt sind.

2. Modul (1) nach Anspruch 1,
**dadurch gekennzeichnet, dass**
in dem Material (19) Kühlkanäle (21) und/oder Heatpipes erzeugt sind.

3. Modul (1) nach Anspruch 1 oder 2,
**dadurch gekennzeichnet, dass**
der Ausdehnungskoeffizient des elektrisch isolierenden Materials (19) an das Material der metallisches Stanzgitter oder Stanzbiegeteile (9, 11) angepasst ist.

4. Modul (1) nach Anspruch 3,
**dadurch gekennzeichnet, dass**
zur Erzeugung einer hohen Zykelfestigkeit der Ausdehnungskoeffizient des elektrisch isolierenden Materials (19) derart ausgewählt wurde, dass eine Verspannung aufgebaut wird, die eine Verbindungsschicht zwischen Bauelement (2) und dem metallischen Stanzgitter oder Stanzbiegeteil (9, 11) mechanisch entlastet.

5. Modul (1) nach Anspruch 4,
**dadurch gekennzeichnet, dass**
die Verbindungsschicht eine Lotschicht (23) ist.

6. Verfahren zur Erzeugung eines Moduls (1) nach einem der vorangehenden Ansprüche 1 bis 5, mit dem Schritt elektrisches Kontaktieren und/oder Befestigen des Bauelements (2), des Metallkörpers (13) und des Distanzhalters (15), mit dem mindestens einen aus einer Ebene heraus gebogenen metallischen Stanzgitter oder Stanzbiegeteil (9) oder dem mindestens einen sich in einer Ebene erstreckenden metallischen Stanzgitter oder Stanzbiegeteil (11), mittels Löten, Reaktionslöten zu intermetallischen Phasen, Schweißen, Laserschweißen, leitendes oder nichtleitendes Kleben,
**dadurch gekennzeichnet, dass**
das elektrisch isolierende Material (19) ein mit wärmeleitenden anorganischen Partikeln gefülltes Epoxid ist.

7. Verfahren nach Anspruch 6,
**dadurch gekennzeichnet, dass**
das elektrisch isolierende Material (19) mittels Spritzguss eingespritzt wird.

8. Verfahren nach Anspruch 7,
**gekennzeichnet durch**
mehrstufiges Spritzgießen, wobei nach ersten Teilvergüssen, metallische Stanzgitter oder Stanzbiegeteile (9, 11) frei geschnitten oder gebohrt werden,
nachfolgendes Spritzgießen zum Auffüllen der entstandenen Trennstellen oder Bohrungen.
